# EUROPEAN PATENT SPECIFICATION

(11) **EP 3 514 264 B1**
(45) Date of publication and mention of the grant of the patent: **21.02.2024**
(21) Application number: 19150932.2
(22) Date of filing: 09.01.2019
(51) Int. Cl.: C30B 15/14, C30B 29/06

(54) **PRODUCTION METHOD OF SINGLE CRYSTAL SILICON**
HERSTELLUNGSVERFAHREN EINES EINKRISTALLSILICIUMS
PROCÉDÉ DE PRODUCTION DE SILICIUM MONOCRISTALLIN

(30) Priority: 19.01.2018 JP 2018007053
(43) Date of publication of application: 24.07.2019
(73) Proprietor: GlobalWafers Japan Co., Ltd., Niigata 957-0197 (JP)
(72) Inventor: Matsumura, Hisashi, Niigata 957-0197 (JP); Tsubota, Hiroyuki, Niigata 957-0197 (JP); Nagai, Yuta, Niigata 957-0197 (JP); Abe, Yoshiaki, Niigata 957-0197 (JP)
(74) Representative: Hoffmann Eitle

(56) References cited:
- EP-A1- 1 774 068
- JP-A- H0 383 887
- JP-A- 2011 162 380
- US-A1- 2009 235 861

## Description

### BACKGROUND OF THE INVENTION

### Field of the Invention

The present invention relates to a production method of single crystal silicon, and more particularly, to a production method of single crystal silicon that can further reduce carbon concentration in the single crystal silicon pulled up from a crucible using the Czochralski (CZ) method.

### Description of the Related Art

The more carbon atoms are contained during growth of single crystal silicon pulled up from a crucible in a Czochralski (herein after referred to as CZ) method, the more crystal defects are subject to be introduced. Thus crystals have been grown so far with devising not to take carbon atoms in the growing crystals as possible. Carbon atoms that are originated both from silicon raw material and surface deposits dissolve into a melt, whereby carbon atoms are taken into growing crystals from the silicon melt.

There are some cases where carbon atoms are originated from members made of carbons (hereinafter referred to as carbon-made members) such as heaters, crucibles and thermal insulators of the pulling apparatus that are made from raw materials containing carbon.

Namely, during melting the silicon raw material, silicon monoxide (SiO) gas evaporates from the silicon melt in the crucible and reacts with the carbon-made members to generate carbon monoxide (CO) gas. The CO gas dissolves into the silicon melt and carbon atoms are resultantly taken into the growing crystals.

As reduction techniques of carbon concentration in the crystals, a cleaning method is disclosed in Japanese Patent No. 5615946, for example; poly-crystal silicon as a raw material is heated up to 350 degrees C to 600 degrees C in an inert gas atmosphere to clean by evaporating organic contaminants on the surface of the poly-crystal silicon.

Japanese Patent No. 2635456 discloses a method where poly-crystal silicon raw material is melted under a furnace pressure of 0.5 kPa to 6 kPa and single crystal silicon is pulled under the furnace pressure of 10 kPa or higher. This method enables to suppress mixing of CO gas evaporating from the carbon-made members into the silicon melt by controlling the furnace pressure in a range from 0.5 kPa to 6 kPa during melting the raw material, and the carbon concentration of the single crystal silicon can be reduced.

Further Japanese Unexamined Patent Application Publication No. 07-89789 discloses a method to reduce generation of CO gas from high-temperature carbon-made members by coating a material such as silicon carbide (SiC) on the surfaces of the heaters and graphite crucibles

Furthermore, US 2009/235861 describes the Czochralski pulling of silicon with a high carbon concentration, wherein in the melting step, the output power of the heaters is kept to a lower level than the one needed for melting.

JP 2011 162380 discloses the Czochralski pulling of silicon, wherein the feedstock is outgased at 700°C for 15 h and JP H03 83887 discloses the pulling of silicon, wherein the feedstock is first outgased at 400°C for 1 h and then before the melting step, the crucible is maintained at 800 to 900°C for 4 hours for a second outgasing with an argon gas flow of 20L/min.

The methods disclosed in the above patent literatures 1-3 can reduce carbon concentration in single crystal silicon, but cannot satisfy the requirements of further reduced carbon concentration in the single crystal silicon.

The present inventers have made intensive effort to further reduce the carbon concentration in the single crystal silicon. The efforts are successful to give findings that a large amount of carbon monoxide gas (CO) and carbon dioxide (CO₂) gas generates from the surface of the carbon-made members during heating in the furnace. Though the causes are not definitive, a cause appears to be probable that moisture (H₂O) of air residual in the furnace reacts with carbon of carbon-made members to generate the CO and CO₂.

In particular, since CO gas, in comparison to CO₂ gas, generates more at a lower temperature ranging from 250 degrees C to 750 degrees C; the CO gas reacts with silicon raw material before melting and form a film containing Si-C bonding. The inventors have found that the film dissolve into the silicon melt and the carbon concentration in the crystals rises, and arrived at the present invention.

The present invention is made with taking the consideration of above situation, it is an object to provide a method of single crystal silicon that enables to reduce the carbon concentration in the single crystal silicon pulled in the CZ method.

### SUMMARY OF THE INVENTION

### Solution to Problems

A production method of single crystal silicon according to the present invention is a production method of single crystal silicon grown using the CZ method according to claim 1;

At the initial stage of melting silicon raw material in the crucible, in the step of setting a heater output in a range from 15% to 50% of a necessary output of completely melting the silicon raw material and keeping the heater output in the range from 3 hours to 20 hours, CO concentration in the furnace is detected and after the concentration goes up to an peak value and then decreases by 30% or more of the peak value, it is desirable to execute the step of forming the silicon melt by setting the heater output necessary to completely melt the silicon raw material.

At the initial stage of melting silicon raw material in the crucible, in the step of setting a heater output in a range from 15% to 50% of a necessary output of completely melting the silicon raw material and keeping the heater output in the range from 3 hours to 20 hours, it is desirable to set a flow rate of an inert gas in the furnace in a range from 200L/min to 400L/min.

In the step of the charging silicon raw material into the crucible, weight of the silicon raw material to be charged is preferably equal to or less than 30 % of the final weight that includes that of the additionally charged silicon raw material.

After the step of setting a heater output in a range from 15% to 50% of a necessary output of completely melting the silicon raw material and keeping the heater output in the range from 3 hours to 20 hours is executed and then the heater output being set to be necessary to completely melt the silicon raw material, and a step of additionally charging the silicon raw material is desirably executed.

This method enables to suppress chemical reactions of CO gas generated from the carbon-made members with a surface substance of the silicon raw materials and also suppress formation of films containing Si-C bonding on the silicon raw material surface. That is, concentration rise of carbon due to a fact that SiC is taken into the silicon melt can be prevented.

In addition, concentration rise of carbon due to a fact that CO gas is taken into the silicon melt can be suppressed by completely degassing CO gas out from the carbon-made members .

The present invention can make it possible to provide a production method of single crystal silicon which can reduce carbon concentration in the silicon crystals pulled up in the CZ method.

### BRIEF EXPLANTION OF DRAWINGS

Fig. 1 is a cross-sectional view showing a configuration of a single crystal pulling apparatus that enables a production method of single crystal silicon according to the present invention;
Fig. 2 is a flowchart of steps of the production method of single crystal silicon according to the present invention;
Figs. 3(A) and 3(B) are graphs showing the results of embodiments according to the present invention; and
Fig. 4 is a graph showing the results of other embodiments.

### DESCRIPTION OF THE PREFERRED EMBODIMENTS

An embodiment of a production method of single crystal silicon according to the present invention will be explained with reference to drawings below. The present invention provides a method to reduce carbon concentration in single crystal silicon that is pulled up from a crucible using the Czochralski method while solving existing problems.

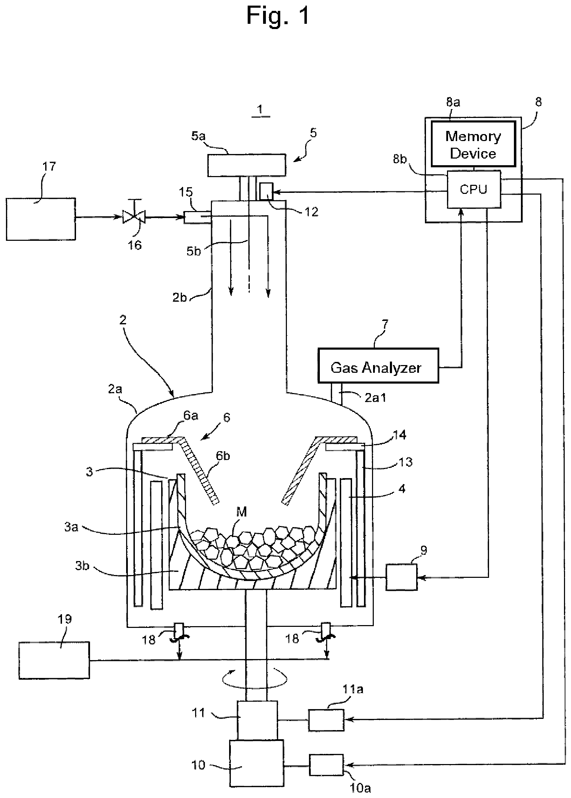

Fig. 1 is a cross-sectional view showing a configuration of a single crystal pulling apparatus that enables a production method of single crystal silicon according to the present invention. The single crystal pulling apparatus 1 includes a furnace 2, a crucible 3 housed in the furnace 2 and a heater 4 for heating to melt charged silicon raw material M in the crucible 3; the furnace 2 is composed of a cylindrical main chamber 2a and a pull chamber 2b that is disposed above and connected to the main chamber 2a, and the crucible 3 is double-structured with a quartz glass crucible 3a inside and a graphite crucible 3b outside.

Thermal insulators 13 are provided around the circumference of the heater 4 along the inside wall of the main chamber 2a to effectively conduct heat generated by the heater to the crucible along the inside wall of the main chamber 2a.

A pulling mechanism 5 for pulling up single crystal silicon (not shown) is disposed above the furnace 2; the pulling mechanism 5 includes a motor-driven winding unit 5a and a pulling wire 5b (partially shown) wound by the winding unit 5a. A seed crystal (not shown) is attached at the tip end of the pulling wire 5b and is configured to be pulled up while growing a single crystal.

A gas inlet 15 is provided at the top of the pull chamber 2b for supplying the inert gas, Ar, into the furnace 2. A gas supply source 17 is connected to the gas inlet 15 through a valve 16; opening the valve 16 causes Ar gas to be supplied into the crucible 3 from the upper part of the pull chamber 2b.

A plurality of exhaust ports 18 are provided at the bottom of the main chamber 2a, and an exhaust pump 19 as an exhaustion means is connected to the exhaust ports 18.

In this configuration, when the pump 19 is driven and the valve 16 is opened, Ar gas is supplied into the furnace 2 through the gas inlet 15 to form a gas flow and exhausted through the exhaust port 18.

Gas flow rate regulation through the gas inlet 15 is achieved by adjusting the degree of opening and closing of the valve 16 and an exhaust speed of the exhaust pump 19.

In the main chamber 2a, a radiation shield 6 having openings in an upper and lower end and surrounding the circumference of the single crystal silicon is disposed above and in the vicinity of the crucible 3, so that the growing crystal is prevented from receiving undesirable radiation heat from the heater 4.

The radiation shield is composed of a horizontal annular part 6a for the outer side and an inclining annular part 6b for the inner side, and the inclining annular part 6b declines linearly toward the center direction downwardly as shown in Fig. 1.

The radiation shield 6 is provided to be movable in up-and-down direction using an elevation mechanism (not shown).

As shown in Fig. 1, the apparatus for pulling up single crystals 1 includes a heater controller 9 for controlling a supply electric power fed to the heater 4 that controls the heating temperature of the silicon raw material, a motor 10 to rotate the quartz glass crucible 3, and a motor controller 10a that controls the number of revolution of the motor 10.

The apparatus further includes an elevation device 11 that adjusts the height of the quartz glass crucible 3, an elevation device controller 11a for controlling the elevation device, and a wire-reel rotation controller 12 that controls the pulling speed and the number of revolution of a growing crystal.

Further, a gas analyzer 7 detecting an amount of CO existing in the furnace 2 through a gas extraction pipe 2a1 is connected to the upper part of the main chamber 2a.

The single crystal pulling apparatus 1 is provided with a computer system 8 including a memory device 8a that stores programs for controlling crystal pulling processes and a central processing unit (CPU) 8b that implements the programs.

Each of the controllers 9, 10a, 11a, 12 and the gas analyzer 7 is connected to the computer system 8.

The production method of Si single crystal using the single crystal pulling apparatus 1 shown Fig. 1 will be explained.

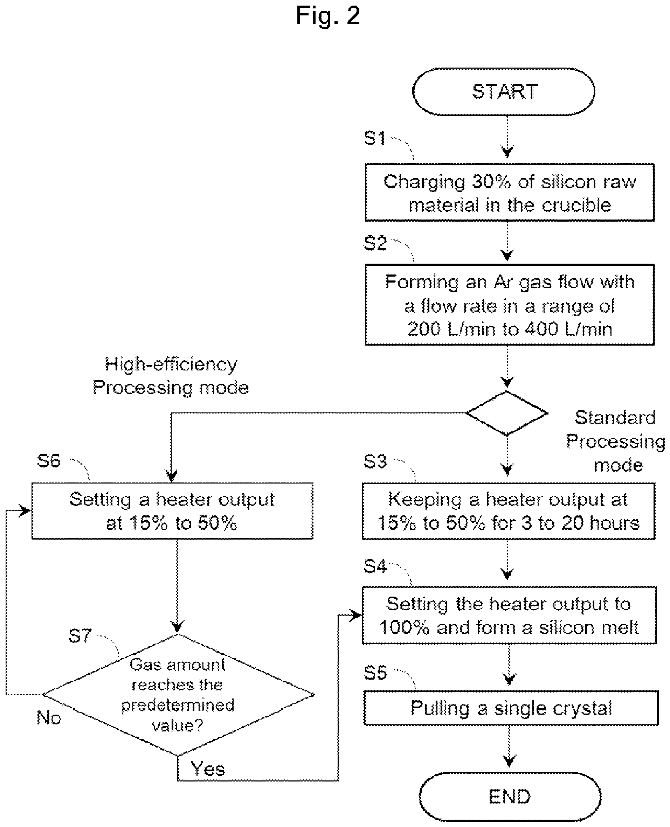

First, a predetermined amount as an initial charging amount of silicon raw material M is charged into the crucible 3 (Step S1 in Fig. 2). This amount is to be equal to or less than 30% of a total amount of silicon raw material enough for growing one single crystal silicon. The reason is to reduce contamination to the silicon raw material M as much as possible because CO gas generates in the furnace at the initial stage of heating the crucible, as described later.

Next, while the exhausting pump being 19 started with the valve 16 kept closed, air in the furnace is evacuated to the outside through the exhausting port 18. Then, the valve 16 is opened to flow Ar gas, forming an Ar gas flow rate in a range from 200 L/min to 400 L/min. By repeating open-close operation multiple times, the degree of vacuum is increased.

This enables evacuation of air in the furnace to the outside and elimination of moisture H₂O of the atmosphere of the furnace and of the member made of carbon.

Next, the heater controller 9 operates by a command from the CPU 8b, based on a program stored in the memory device 8a, to supply power to the heater 4 to heat the crucible 3, and melting operation of the silicon raw material M is started (Step S3 in Fig. 2).

For a predetermined period of time from start-up of the melting operation, an output W of the heater 4 is kept in a range from 15% to 50% of the output (100%) of the heater output that is necessary to melt the silicon raw material M completely. With the low output the silicon raw material M does not melt, but heating at relatively low temperature in a range from 250 degrees C to 750 degrees C causes to generate CO gas from carbon-made members, such as the heater 4, the crucible 3 and the thermal insulator 13, and can result to evacuate the CO gas, that is, to replace it with Ar.

A low output state of the heater 4 is kept for a predetermined period; that is, a time range from 3 hours to 20 hours (In a standard mode case in Fig. 2). With this condition, because the temperature of the silicon raw material M can be kept low, a reaction of the CO gas with the silicon raw material M at surface can be suppressed, even if CO gas generates from the carbon-made members in the furnace.

In a case where the heater output is less than 15% of the output of the heater output needed to melt the silicon raw material M completely, it is not desirable because the temperature of the carbon-made members fails to rise enough to release CO gas completely. In contrast, in a case where the heater output is more than 50% of the output of the heater output needed to melt the silicon raw material M completely, it is not desirable because, when the temperature of the silicon raw material M rises before the temperature of the carbon-made members in the furnace rises to a predetermined value, then the temperature enhances the surface reaction of the CO gas with the silicon raw material, and the concentration of carbon in the silicon melt increases.

As a step S3 in Fig.2, keeping the output of the heater 4 to be low for a period of 3 hours to 20 hours enables CO gas generated from the carbon-made members in the furnace to be exhausted to the outside.

When the holding time of keeping the heater output low is less than 3 hours, it is not desirable because the outgassing from the carbon-made members in the furnace is incomplete and the holding time of more than 20 hours will not give any further effects.

As described above, the flow rate of Ar gas in the furnace is in a range from 200 L/min to 400 L/min. To suppress the reaction between the silicon raw materials and the CO gas, it is desirable that the Ar gas flow is as much as possible.

However, it is not desirable because the exhaustion effect of the CO gas is small when the flow rate is less than 200 L/min. In a case when the flow rate is more than 400 L/min, the exhaustion effect of CO gas becomes saturated and there arises a trouble of stopping of the pump due to heavy load of a large amount of Ar gas exhausting. A large amount of Ar gas flow rate may undesirably cause cost rise.

After the step S3, the heater controller 9 is controlled by a command from the CPU 8b to switch the heater output W of the heater 4 to an output necessary to melt the silicon raw material M completely (Step S4 in Fig. 2).

This procedure makes the whole silicon raw material M in the crucible 3 melt. When the silicon raw material M gets melted, the silicon melt generates SiO gas, and CO gas is generated by a reaction of the carbon-made members in the furnace, such as the heater 4, the crucible 3 and the thermal insulator 13, with the SiO gas. The generation of CO gas gives little influences because it occurs at a downstream side of the exhausting pump 19 rather than the silicon raw material M from a viewpoint of a gas flowing path.

In the step S3, holding time of keeping the heater output low is a predetermined value, that is, 3 hours to 20 hours. However, utilization of a gas analyzer 7 shown in Fig. 1, a quadrupole mass spectrometer for example, for monitoring the amount of CO gas may allow an improvement of production efficiency (High efficiency mode case in Fig. 2).

Namely, an output W of the heater 4 is kept in a range from 15% to 50% of the output (100%) of the heater output that is necessary to melt the silicon raw material M completely (Step S6 in Fig. 2).

The CPU 8b monitors the amount of CO gas in the furnace based on results of analysis with the gas analyzer 7. After due to the heating process of S3 the concentration has risen to a peak value and turned to decrease, then the CPU 8b detects a timing when the concentration decreases by 30% or more of the peak value (Step S7 in Fig. 2).

The reason why the timing is when the concentration decreases by 30% or more of the peak value is because there is a case the amount of the CO gas may increase again after the concentration has risen to a peak value and turned to decrease, and variation in analysis is also taken into account.

When the requirement of the step S7 is satisfied, the heater controller 9 is controlled by a command from the CPU 8b to switch the heater output W of the heater 4 to an output necessary to melt the silicon raw material M completely (Step S4 in Fig. 2).

With this procedure, there is no need to set the holding time of the step S3 to be the predetermined value ranging from 3 hours to 20 hours but it is possible to set an appropriate time; thus a wasteful heating time is eliminated and production efficiency can be improved.

The initial charged weight of the silicon raw material is equal to or less than 30% of the final charged weight.

Reducing the charged silicon raw material enables to prevent formation of a film containing Si-C bonding on the surface of silicon raw material and an increase of carbon concentration in the silicon melt.

Additional charging of the remaining silicon raw material M after completion of CO gas emission from the carbon-made members enables to reduce the amount of carbon contamination.

Consequently, the timing of additional charging of the silicon raw material M is preferably determined after the step S3 or S7; the output of the heater 4 is set to 15% to 50% of the output necessary to melt the silicon raw material M completely and to be kept for in a range from 3 hours to 20 hours. A step of additionally charging the silicon raw material to the crucible 3 is preferably executed before the output of the heater 4 is set to the necessary output for melting the silicon raw material M completely and the silicon raw material melt to form a silicon melt (Step S4).

After the whole silicon raw material is melted and a silicon melt is formed, processing is shifted to a single crystal pulling step (Step S5 in Fig. 2).

Then the elevation device 11a and the wire-reel rotation controller 12 start to operate by a command from the CPU 8b and the height of the rotating crucible 3 is adjusted and the wire winding mechanism 5a starts to operate to move the wire 5b downward.

A seed crystal attached to the distal end of the wire 5b comes into contact with the silicon melt and the tip portion of the seed crystal dipped into the melt.

Then after the temperature of the melt is adjusted by the heater output, necking is carried out to form a neck part having a diameter of 3 mm to 6 mm and a length of 100 mm to 400 mm.

After this process, a condition of parameters, such as electric power supply to the heater 4, a pulling speed of a single crystal that is typically a few millimeters/min, is adjusted by commands from the CPU 8b, then pulling processes are carried out in turn, such as a crowning process to enlarge the diameter of the crystal to a straight body diameter, a process to form a straight body that is to be a product, and a process to form a tail part in which the diameter of the crystal is reduced from the straight body diameter.

As described above, in an embodiment according to the present invention, at the early stage of melting the silicon raw material M in the crucible 3, CO gas generated from the carbon-made members in the furnace is released under the condition that an output of the heater 4 is kept in a range from 15% to 50% of the output necessary to completely melt the silicon raw material M, and then evacuated. After that the output of the heater is raised to form a silicon melt in the crucible 3.

This process can suppress reaction of CO gas generated from the carbon-made members with the surface of the silicon raw material and resultantly formation of a film containing Si-C bonding on the surface of the silicon raw material M. Namely, an increase of carbon concentration in the silicon melt due to the intake of the film containing Si-C bonding into the melt can be suppressed.

In the above embodiment the inert gas introduced to the furnace is Ar, but not restricted to Ar. Other inert gas, such as He gas, may be used.

A production method of single crystal silicon according to the present invention will be describe based on the embodiment. Following experiments were carried out based on the embodiment.

### Experiment 1

In Experiment 1, an amount of CO gas generated from carbon-made members was investigated.

Sample 1 is a piece of thermal insulator having a dimension of 10 mm × 10 mm × 5 mm and Sample 2 is a piece of graphite made by a cold isostatic pressing method (CIP) having a dimension of 10 mm × 10 mm × 5 mm; both of the samples are materials used in a furnace.

The inside of the furnace was heated up to 1000 degrees C at a temperature rising speed of 10 degrees/min and He gas was flown at a flow rate of 50 mL/min at an atmospheric pressure.

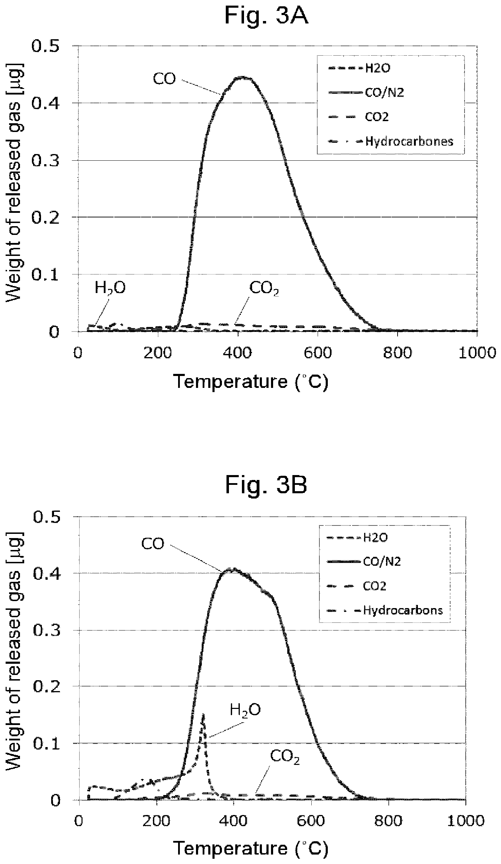

Weights of the generated gas in the furnace were analyzed with temperature programmed desorption mass spectroscopy (TPD-MS), and the results are shown Fig. 3; results of the Sample 1 and the Sample 2 are given in Figs. 3A and 3B, respectively. In Figs. 3A and 3B, the vertical axis is weight (µg) of generated gas from the carbon-made members and the horizontal axis is temperature inside the furnace.

As shown in Figs. 3A and 3B, it is confirmed that both the sample 1 and sample 2 generated larger amount of generated CO gas when the temperature inside the furnace was between 250 degrees C and 750 degrees C. As clearly seen from Figs. 3a and 3B, the weight of the generated CO gas is heavier than the weight of the generated CO₂ gas; it is confirmed that CO gas gives greater influence to the concentration of carbon in the single crystal silicon.

To form a silicon melt by melting a silicon raw material typically requires about 1800 degrees C at the maximum temperature in the furnace. There usually is a temperature distribution inside the furnace; the temperature in the vicinity of the heater as a heat source in Fig. 1 is the highest. When the heater output is rapidly raised to an output necessary to melt the silicon raw material completely, the vicinity of the heater and the silicon raw material in the crucible become a high temperature state but carbon-made members disposed away from the heater are still in a low temperature state. At a time when the temperature of the carbon-made members disposed away from the heater rises 250 degrees C to 750 degrees C, the silicon raw material becomes at a rather high temperature, and the reaction between the silicon raw material and the generated CO gas is promoted thereby.

Consequently the heater output is set to an output that can maintain the temperature of the carbon-made members disposed away from the heater in a range from 250 degree C to 750 degrees C and the holding time is set in a range from 3 hours to 20 hours. The heater output enabling to maintain the temperature of the carbon-made members in a range from 250 degree C to 750 degrees C corresponds to 15% to 50% of the heater output necessary to melt the silicon raw material completely.

### Experiment 2

In Experiment 2, 100 kg of silicon raw material as an initial charging weight was charged in a 32-inch crucible and melted under the condition where the holding time of heater output at the initial stage of melting of the raw material and Ar flow rate in the furnace are shown in Table 1.

At the initial stage of melting raw material, after the predetermined holding time, 270 kg of silicon raw material was additionally charged and the heater output was increased to melt the whole silicon raw material to form a silicon melt, and then a crystal having a diameter of 300 mm was pulled up.

The carbon concentration at a position where a solidification ratio of the pulled crystal is 85% was measured with a Fourier-transform infrared spectrometer (FT-IR). Conditions for each of the embodiments and the results are shown in Table 1.

**Table 1**

| | Ratio of initial heater output (%) | Holding time (Hours) | Ar Flow rate | Carbonconcentration |
|---|---|---|---|---|
| | | | (L/min) | (10¹⁵ atoms/cm³) |
| Embodiment 1 | 15 | 7 | 300 | 1.0 |
| Embodiment 2 | 30 | 7 | 300 | 0.8 |
| Embodiment 3 | 50 | 7 | 300 | 0.7 |
| Embodiment 4 | 30 | 3 | 300 | 1.0 |
| Embodiment 5 | 30 | 20 | 300 | 0.6 |
| Embodiment 6 | 30 | 7 | 200 | 1.0 |
| Comparative example 1 | 10 | 7 | 300 | 1.7 |
| Comparative example 2 | 60 | 7 | 300 | 2.0 |
| Comparative example 3 | 30 | 2 | 300 | 1.5 |
| Comparative example 4 | 30 | 7 | 100 | 1.8 |

As shown in Table 1, values of carbon concentration equal to or lower than 1.0×10¹⁵ atoms/cm³ are obtained in embodiments 1 to 6; the results shows the effectiveness of the present invention.

In comparative example 1, the carbon concentration was a high value of 1.5×10¹⁵ atoms/cm³. This is thought to be because, with a low heater output of a value of 10%, the temperature of the carbon-made members in the furnace did not rise enough and CO gas was not released completely.

In comparative example 2, the carbon concentration was a high value of 2.0×10¹⁵ atoms/cm³. This is thought to be because, due to a high heater output of a value of 60%, before the temperature of the carbon-made members in the furnace rose, the temperature of the silicon raw material rose up and promoted the reaction between the surface of the silicon raw material and CO gas; this resulted in an increase of carbon concentration in the silicon melt.

In comparative example 3, the carbon concentration was a high value of 1.5×10¹⁵ atoms/cm³. This is thought to be because the holding time too short, that is, 2 hours, the CO gas was not completely released.

In comparative example 4, the carbon concentration was a high value of 1.8×10¹⁵ atoms/cm³. This is thought to be because the Ar flow rate was too low, 100 L/min, CO gas was not effectively evacuated; this caused to increase carbon concentration due to reaction of CO gas in the furnace.

### Experiment 3

In Experiment 3, as in the embodiment, it was investigated whether controlling the heater output at an initial stage of heating the crucible was effective.

In embodiments 7 and 8, a silicon melt was formed with a heater output of 100 kW after the crucible with a heater output of 30 kW was kept for 3 hours; the heater output was 30% of a heater output of 100 kW necessary to melt silicon raw material necessary for growing a single crystal with a diameter of 150 mm.

The flow rate of Ar in the furnace was set to be 150 L/min in the embodiment 7 and 120 L/min in the embodiment 8.

In comparative examples 5 and 6, a silicon melt was formed with a heater output of 100 kW from the beginning of crucible heating. The flow rate of Ar in the furnace was set to be 150 L/min in the comparative example 5, and 120 L/min in the comparative example 6.

Other conditions were all the same for embodiments 7 and 8 and the comparative examples 5 and 6.

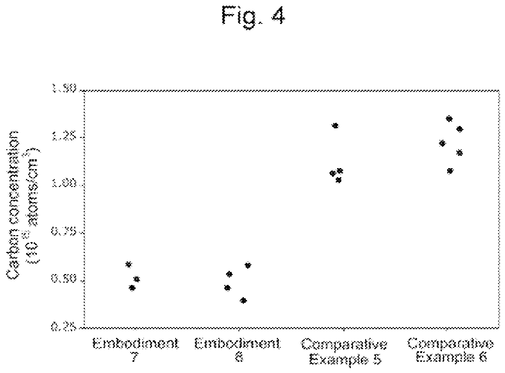

Graphs in Fig. 4 show the results of the embodiments 7 and 8, and examples 5 and 8. On the graph in Fig. 4, every measured carbon concentration is plotted on the vertical axis in a unit of 10¹⁵ atoms/cm³ for every condition, which is placed on the horizontal axis as a group, of embodiments 7 and 8 and comparative examples 5 and 6.

As the graph shows, it is confirmed that carbon concentration in the crystal remarkably decreases to approximately 58% in comparison with a conventional method by keeping the heater output to be lower at the initial stage of heating.

From the results of the embodiments, it is confirmed that the present invention can greatly reduce carbon concentration in the crystals in comparison to conventional methods.

### EXPLANATION OF THE REFERENCE SIGNS

- 1: single crystal pulling apparatus
- 2: furnace
- 2a: main chamber
- 2b: pull chamber
- 3: crucible
- 4: heater
- 5: pulling mechanism
- 6: radiation shield
- 7: gas analyzer
- 8: computer system
- 8a: memory device
- 8b: CPU
- 9: heater controller
- 10: motor for crucible revolution

## Claims

1. A production method of single crystal silicon using the Czochralski method, comprising steps of:
charging silicon raw material into a crucible (3);
setting a heater output, at an initial stage of melting the silicon raw material in the crucible (3), in a range from 15% to 50% of an output of the heater output that is necessary to completely melt the silicon raw material for setting the temperature in the crucible in a range from 250 degrees C to 750 degrees C, and keeping the heater output in a range from 3 hours to 20 hours;
melting the silicon raw material to a silicon melt by setting the heater output to an output necessary to completely melt the silicon raw material; and
pulling single crystal silicon from the crucible (3) where the silicon melt is formed;
wherein at the initial stage of melting the silicon raw material in the crucible (3), in the step of setting the heater output in the range from 15% to 50% of the output of the heater output that is necessary to completely melt the silicon raw material for setting the temperature in the crucible in a range from 250 degrees C to 750 degrees C and the heater output being kept in the range from 3 hours to 20 hours, a flow rate of an inert gas in the furnace is set in a range from 200L/min to 400L/min.

2. The production method of single crystal silicon according to claim 1, wherein at the initial stage of melting the silicon raw material in the crucible (3), in the step of setting the heater output in the range from 15% to 50% of the output of the heater output that is necessary to completely melt the silicon raw material for setting the temperature in the crucible in a range from 250 degrees C to 750 degrees C and the heater output being kept in the range from 3 hours to 20 hours, after CO concentration in a furnace (2) is detected and the concentration goes up to an peak value and then decreases by 30% or more of the peak value,
a step of forming the silicon melt is implemented by setting the heater output necessary to completely melt the silicon raw material.

3. The production method of single crystal silicon according to claims 1 or claim 2, wherein in the step of the charging silicon raw material into the crucible (3), weight of the silicon raw material to be charged is equal to or less than 30 % of a final weight including the weight of additionally charged silicon raw material.

4. The production method of single crystal silicon according to claim 3, wherein
after the step of setting the heater output in the range from 15% to 50% of the output of the heater output necessary to completely melt the silicon raw material for setting the temperature in the crucible in a range from 250 degrees C to 750 degrees C and keeping the heater output in the range from 3 hours to 20 hours, the heater output is set to the output necessary to completely melt the silicon raw material and a step of additional charging of the silicon raw material into the crucible (3) is executed.

## Patentansprüche

1. Verfahren zur Herstellung von einkristallinem Silicium unter Verwendung des Czochralski-Verfahrens, umfassend die Schritte:
Einfüllen von Silicium-Rohmaterial in einen Tiegel (3);
Einstellen einer Heizleistung in einem anfänglichen Schmelzstadium des Silicium-Rohmaterials in dem Tiegel (3) in einem Bereich von 15% bis 50% einer Leistung der Heizleistung, die notwendig ist, um das Silicium-Rohmaterial vollständig zu schmelzen, um die Temperatur in dem Tiegel in einem Bereich von 250 Grad C bis 750 Grad C einzustellen, und die Heizleistung in einem Bereich von 3 Stunden bis 20 Stunden zu halten;
Schmelzen des Silicium-Rohmaterials zu einer Siliciumschmelze durch Einstellen der Heizleistung auf eine Leistung, die zum vollständigen Schmelzen des Silicium-Rohmaterials erforderlich ist; und
Entnehmen von einkristallinem Silicium aus dem Tiegel (3), in dem die Siliciumschmelze gebildet wird;
wobei in dem anfänglichen Schmelzstadium des Silicium-Rohmaterials in dem Tiegel (3) in dem Schritt des Einstellens der Heizleistung in dem Bereich von 15% bis 50% der Leistung der Heizleistung, die notwendig ist, um das Silicium-Rohmaterial vollständig zu schmelzen, um die Temperatur in dem Tiegel in einem Bereich von 250 Grad C bis 750 Grad C einzustellen, und wobei die Heizleistung in dem Bereich von 3 Stunden bis 20 Stunden gehalten wird, eine Strömungsrate eines Inertgases in dem Ofen in einem Bereich von 200L/min bis 400L/min eingestellt wird.

2. Verfahren zur Herstellung von einkristallinem Silicium nach Anspruch 1, wobei in dem anfänglichen Schmelzstadium des Silicium-Rohmaterials im Tiegel (3) im Schritt des Einstellens der Heizleistung im Bereich von 15% bis 50% der Leistung der Heizleistung, die zum vollständigen Schmelzen des Silicium-Rohmaterials notwendig ist, um die Temperatur im Tiegel in einem Bereich von 250 Grad C bis 750 Grad C einzustellen, und wobei die Heizleistung im Bereich von 3 Stunden bis 20 Stunden gehalten wird, nachdem eine CO-Konzentration in einem Ofen (2) erfasst wird und die Konzentration auf einen Spitzenwert ansteigt und dann um 30% oder mehr des Spitzenwertes abfällt,
ein Schritt zum Bilden der Siliciumschmelze durch Einstellen der Heizleistung durchgeführt wird, die zum vollständigen Schmelzen des Silicium-Rohmaterials erforderlich ist.

3. Verfahren zur Herstellung von einkristallinem Silicium nach Anspruch 1 oder Anspruch 2, wobei in dem Schritt des Einfüllens von Silicium-Rohmaterial in den Tiegel (3) ein Gewicht des einzufüllenden Silicium-Rohmaterials gleich oder weniger als 30% eines Endgewichts, einschließlich des Gewichts von zusätzlich eingefülltem Silicium-Rohmaterial, beträgt.

4. Verfahren zur Herstellung von einkristallinem Silicium nach Anspruch 3, wobei nach dem Schritt des Einstellens der Heizleistung im Bereich von 15% bis 50% der Leistung der Heizleistung, die notwendig ist, um das Silicium-Rohmaterial vollständig zu schmelzen, um die Temperatur im Tiegel in einem Bereich von 250 Grad C bis 750 Grad C einzustellen und die Heizleistung im Bereich von 3 Stunden bis 20 Stunden zu halten, die Heizleistung auf die Leistung eingestellt wird, die zum vollständigen Schmelzen des Silicium-Rohmaterials erforderlich ist, und ein Schritt des zusätzlichen Einfüllens des Silicium-Rohmaterials in den Tiegel (3) ausgeführt wird.

## Revendications

1. Procédé de production de silicium monocristallin à l'aide du procédé de Czochralski, comprenant des étapes consistant à :
charger de la matière brute de silicium dans un creuset (3) ;
régler une sortie d'élément chauffant, à un stade initial de fusion de la matière brute de silicium dans le creuset (3), dans une plage de 15 % à 50 % d'une sortie de la sortie d'élément chauffant qui est nécessaire pour faire fondre complètement la matière brute de silicium pour régler la température dans le creuset dans une plage de 250 degrés C à 750 degrés C, et maintenir la sortie d'élément chauffant dans une plage de 3 heures à 20 heures ;
faire fondre la matière brute de silicium en une matière fondue de silicium en réglant la sortie d'élément chauffant sur une sortie nécessaire pour faire fondre complètement la matière brute de silicium ; et
retirer le silicium monocristallin du creuset (3) où la matière fondue de silicium est formée ;
dans lequel au stade initial de fusion de la matière brute de silicium dans le creuset (3), à l'étape de réglage de la sortie d'élément chauffant dans la plage de 15 % à 50 % de la sortie de la sortie d'élément chauffant qui est nécessaire pour faire fondre complètement la matière brute de silicium pour régler la température dans le creuset dans une plage de 250 degrés C à 750 degrés C et la sortie d'élément chauffant étant maintenue dans la plage de 3 heures à 20 heures, un débit d'un gaz inerte dans le four est réglé dans une plage de 200 L/min à 400 L/min.

2. Procédé de production de silicium monocristallin selon la revendication 1, dans lequel au stade initial de fusion de la matière brute de silicium dans le creuset (3), à l'étape de réglage de la sortie d'élément chauffant dans la plage de 15 % à 50 % de la sortie de la sortie d'élément chauffant qui est nécessaire pour faire fondre complètement la matière brute de silicium pour régler la température dans le creuset dans une plage de 250 degrés C à 750 degrés C et la sortie d'élément chauffant étant maintenue dans la plage de 3 heures à 20 heures, après qu'une concentration de CO dans un four (2) a été détectée et que la concentration monte jusqu'à une valeur de pic puis diminue de 30 % ou plus de la valeur de pic,
une étape de formation de la matière fondue de silicium est mise en oeuvre en réglant la sortie d'élément chauffant nécessaire pour faire fondre complètement la matière brute de silicium.

3. Procédé de production de silicium monocristallin selon la revendication 1 ou la revendication 2, dans lequel à l'étape du chargement de la matière brute de silicium dans le creuset (3), le poids de la matière brute de silicium à charger est égale ou inférieure à 30 % d'un poids final incluant le poids de la matière brute de silicium chargée en plus.

4. Procédé de production de silicium monocristallin selon la revendication 3, dans lequel
après l'étape de réglage de la sortie d'élément chauffant dans la plage de 15 % à 50 % de la sortie de la sortie d'élément chauffant nécessaire pour faire fondre complètement la matière brute de silicium pour régler la température dans le creuset dans une plage de 250 degrés C à 750 degrés C et de maintien de la sortie d'élément chauffant dans la plage de 3 heures à 20 heures, la sortie d'élément chauffant est réglée sur la sortie nécessaire pour faire fondre complètement la matière brute de silicium et une étape de chargement supplémentaire de la matière brute de silicium dans le creuset (3) est mise en oeuvre.
